Europäisches Patentamt

European Patent Office

Office européen des brevets

(19)

(11) Publication number: **0 204 762 B1**

# EUROPEAN PATENT SPECIFICATION
## published in accordance with Art. 158(3) EPC

(12)

(45) Date of publication of patent specification: **27.02.91**   (51) Int. Cl.⁵: **H03K 19/003**

(21) Application number: **85906107.9**

(22) Date of filing: **13.11.85**

(86) International application number:
**PCT/US85/02242**

(87) International publication number:
**WO 86/03632 (19.06.86 86/13)**

(54) **Integrated logic circuit.**

(30) Priority: **10.12.84 US 680167**

(43) Date of publication of application:
**17.12.86 Bulletin 86/51**

(45) Publication of the grant of the patent:
**27.02.91 Bulletin 91/09**

(84) Designated Contracting States:
**BE DE FR GB NL SE**

(56) References cited:
**US-A- 3 818 245**
**US-A- 4 069 430**
**US-A- 4 274 014**

(73) Proprietor: **AMERICAN TELEPHONE AND TELEGRAPH COMPANY**
**550 Madison Avenue**
**New York, NY 10022(US)**

(72) Inventor: **KIRSCH, Howard, Clayton**
**Box 207A RD No. 2**
**Oak Hill Road Emmaus, PA 18049(US)**

(74) Representative: **Buckley, Christopher Simon Thirsk et al**
**AT&T (UK) LTD. AT&T Intellectual Property Division 5 Mornington Road**
**Woodford Green, Essex IG8 OTU(GB)**

**Description**

This invention relates to integrated circuits including logic circuits.

In the production of integrated circuits, the reduction in the size of transistors is of great significance, in order to increase the functionality on a given semiconductor chip. However, as device geometries decrease, failure modes become apparent that were not so important at larger device sizes. For example, the "hot electron" effect has received considerable attention. This effect relates to the fact that in a field effect transistor, as the channel length decreases, the electric field in the channel increases if the operating voltage is maintained at previous levels (for example, at five volts). This increased electric field may cause the electrical carriers (i.e. holes or electrons) to gain sufficient energy as they traverse the channel to Induce avalanching. When avalanching occurs, additional carriers are generated and some of these carriers may become trapped in the gate oxide region overlying the channel. These trapped charges may produce what are referred to as "fast states", which have deleterious effects on the subsequent device operation. For example, it is known that trapped charges can reduce the gain of the device, as well as change the threshold voltage; that is, the voltage between the gate and the source at which the device begins to conduct through the channel.

While various approaches have been suggested to reduce this problem, e.g. to reduce the device operating voltages (generally undesirable), there is still need for improvement.

U.S.A Patent No. 4 274 014 discloses a switched current source that includes a complementary inverter. A current mirror is included, in order to limit the current flow when the inverter is switched on. This is achieved by including a "slave" mirror transistor (p26] in the inverter current path, which transistor has approximately the same gate-to-source voltage as that of the "master" constant current transistor (p24]. Therefore, the voltage on the gate of the mirror transistor (node 17] varies as necessary to maintain the same current as that flowing through the "master" transistor (p26], which is a fixed bias current.

According to this invention there is provided an integrated circuit as claimed in claim 1.

The voltage on the gate of the protective transistor is chosen so that the drain-to-source voltage across a transistor being protected does not exceed a desired value. The protective voltage is typically less than one threshold voltage more negative or more positive than the power supply voltages applied to the logic transistors. Logic devices that can advantageously be protected by the present technique include inverters, NAND gates, and NOR gates. In one embodiment, the control voltage on the gate of the protective transistor is regulated at a given voltage. The present technique provides that portions of an integrated circuit (e.g. memory cells) can operate at the full power supply voltage, whereas other portions (e.g., logic circuits) can be protected from the full power supply voltage, while still supplying the full power supply output voltage swing.

The invention will now be described with reference to the accompanying drawings, in which:

FIG. 1    shows an inverter embodying the invention;

FIG. 2    shows a NAND gate embodying the invention;

FIG. 3    shows a NOR gate embodying the invention;

FIG. 4    shows one technique for clamping the gate voltage on the protective transistor; and FIG. 5 shows a circuit suitable for providing a constant voltage to the gate of the protective transistor.

The following detailed description relates to a logic circuit implemented in complementary transistor technology having improved protection from operating voltages. Such voltages can otherwise cause degradation due to excessive fields in the channel of a field effect transistor, or by other degradation mechanisms. The present technique will be illustrated in terms of Complementary Metal Oxide Semiconductor (CMOS) field effect technology. However, the circuit technique is applicable to other forms of complementary transistors. For example, when complementary transistors become available in gallium arsenide (or other III-V semiconductor material) technology, they can be protected by the present technique.

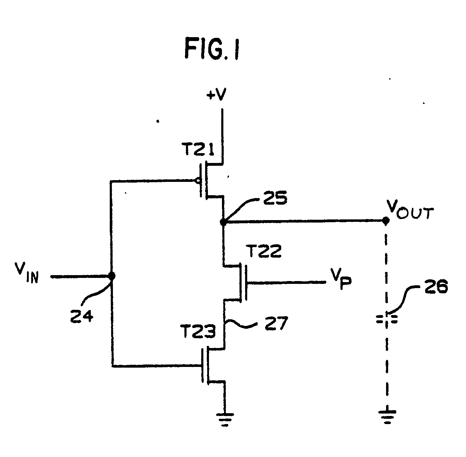

Referring to FIG. 1, a simple inverter is shown, which is included in the term "logic circuit" as used herein. In this circuit a protective transistor T22 has a source-drain path that is serially inserted in the path between the drains of logic transistors T21 and T23. Note that complementary transistors T21, T23 otherwise would form by themselves a conventional complementary pair. The input logic signal is applied from common input node 24 to the gates of transistors T21 and T23, whereas the output logic signal is taken from the drain of p-channel transistor T21 and the drain of n-channel transistor T22, at common output node 25. For typical MOS devices, the n-channel transistors are degraded more rapidly by excessive fields than are p-channel transistors. Hence, protective transistor T22 in the inventive technique provides that the source-drain potential of n-channel transistor T23 is limited so as not to exceed a given value, even though the positive power supply potential ( +V) increases beyond this value. To achieve this end, the gate voltage of protective transistor T22 is placed at voltage $V_p$ with respect to ground. This voltage is a d.c. value, which may be a constant, or may be clamped so as to not exceed a given amount, as explained further below. The drain voltage (referenced to ground) on T23 is then limited to $V_p$ -$V_{th}$, where $V_{th}$ is the threshold voltage drop across protective transistor T22. The positive voltage ( +V), and the negative voltage (ground) are typically supplied by power terminals adapted to contact the appropriate power supply potentials.

In typical operation the positive power supply voltage ( +V) is in the range of 4.5 to 5.5 volts and typically about 5.0 volts, which is conventially designated $V_{cc}$. The gate voltage $V_p$ on protective transistor T22 is typically about 4.5 to 5.5 volts. Transistor T22 has a threshold voltage drop of typically 1 to 2 volts, and in an exemplary case about 1.6 volts. This implies that the source voltage of protective transistor T22 (node 27), which supplies the drain voltage of logic transistor T23, does not exceed approximately 3.9 volts. The precise degree that excessive voltages reduce transistor performance over time varies with transistor type and geometry. However, even a relatively small reduction in applied voltage (e.g., 20 percent) typically has a relatively large effect (e.g., a 100 percent increase) on the useful life of a transistor. Thus, n-channel transistor T23 has substantially increased protection against degradation effects induced by high operating voltages.

Furthermore, note that in the present technique, the output voltage swing at output node 25 still achieves the full power supply excursion. That is, when a positive input voltage is present at input node 24, p-channel transistor T21 is placed in a non-conducting state, whereas n-channel transistor T23 conducts. Hence, node 25 drops substantially to the ground (0 volts) potential. Note that this can be obtained because the gate voltage on protective transistor T22 is sufficiently positive with respect to its source that T22 also conducts, allowing current flow between the output node 25 and ground. Conversely, when the input voltage at node 24 is in a low voltage state, p-channel transistor T21 conducts, whereas n-channel transistor T23 is turned off. Hence, the voltage at output node 25 rises to substantially the positive power supply potential. Hence, in a typical case, a full 0-5 volt logic swing is obtained, while limiting the potential across n-channel transistor T23 to a substantially lower value than the most positive logic swing.

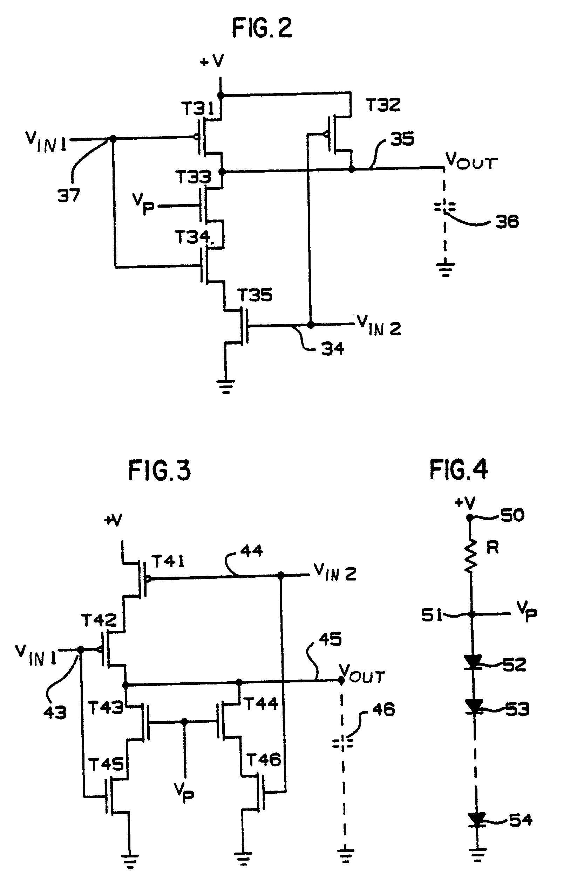

The inventive technique can be extended from the case of the simple inverter to more complex logic. Referring to FIG. 2, a two input NAND gate is illustrated. One logic input signal ($V_{IN1}$) is applied to the gate of p-channel transistor T31 and n-channel transistor T34, whereas the other logic input signal ($V_{IN2}$) is applied to the gate of p-channel transistor T32 and n-channel transistor T35. As indicated, the source and drain connections of the p-channel transistors T31 and T32 are in parallel, being located between the positive voltage +V and the output node 35. Located in series with the source-drain path of logic transistors T34 and T35 is protective transistor T33. Applied to the gate of transistor T33 is the protective voltage $V_p$, which can have the values as indicated above. Thus, the drain-to-source voltage across transistors T34 and T35 are limited to less than the full power supply voltage +V, while $V_{OUT}$ still obtains the full power supply swing. Additional inputs for the NAND gate can be provided by adding p-channel transisors in parallel, and n-channel transistors in series, in an analogous manner.

A two input NOR gate is illustrated in FIG. 3. As indicated, one logic input signal ($V_{IN1}$) is applied to the common gate connection of p-channel transistor T42 and n-channel transistor T45, at node 43. The other input signal ($V_{IN2}$) is applied to the common gate node 44 of transistors T41 and T46. In the circuit illustrated, the protective transistors are T43 and T44, having a common gate node connected to voltage $V_p$ as above. Note that protective transistor T43 limits the voltage on logic transistor T45, whereas protective transistor T44 limits the voltage on logic transistor-T46. The use of two protective transistors in this manner provides a degree of decoupling between the logic transistors T45 and T46. However, if desired, a single protective transistor (e.g., T43) can be used, by connecting the drain of transistor T46 to the drain of transistor T45.

The addition of the protective transistor has been found to have a minimal effect on the speed of operation of the logic circuits. In an illustrative embodiment, a five volt power supply is utilized and the transistors have a channel length of about 1.3 micrometers. For the circuit of FIG. 1 with transistor T21 having a channel width of 50 micrometers, protective transistor T22 having a channel width of 50 micrometers, and transistor T23 having a channel width of 30 micrometers, a typical propagation delay of about 1.5 nanoseconds is obtained when driving a load capacitor (26) of 1 picofarad. To achieve an approximately comparable delay when driving a 1 picofarad load for the circuit of FIG. 2, transistors T31, T32 have channel widths of 50 micrometers each, transistors T34, T35 have channel widths of 60 micrometers each, and transistor T33 has a channel width of 50 micrometers. For the circuit of FIG. 3, transistors T41 and T42 have channel widths of 100 micrometers each, transistors T43, T44 have channel widths of 50 micrometers each, and transistors T45, T46 have channel widths of 30 micrometers each, to obtain the above-noted performance.

A common supply voltage can supply the protective gate voltage ($V_p$) to all the protective transistors, so that only a single protective bias source is needed on an integrated circuit chip, or wafer, in the case of wafer scale integration. If desired, different portions of the circuit can have a different gate voltage on the protective transistors. The circuit that generates $V_p$ typically is also implemented on the same integrated circuit as the logic circuits protected. Then, $V_p$ may conveniently be derived from the electrical potentials that power the logic circuits. However, $V_p$ may be provided from an external source if desired. It is possible to have $V_p$ track the positive power supply voltage until a certain level is reached, above which $V_p$ is clamped at a constant value. For example, referring to FIG. 4, the positive power supply voltage V + is applied to node 50. The voltage $V_p$ is then impressed on node 51 through the current limiting resistor (R). The voltage at node 51 is clamped by means of the diodes (52-54), as indicated. With silicon p-n junctions having a typical voltage drop of approximately 0.6 volts, it can be seen that a series connection of 8 such diodes then provide a maximum $V_p$ voltage of about 4.8 volts. When the positive power supply voltage exceeds 4.8 volts, the $V_p$ voltage is then clamped to this fixed value. However, at lower voltages, for example, if the circuit is operating at a voltage of 4.5 volts, then $V_p$ is also approximately 4.5 volts. This provides for a suitably high speed of operation of the logic circuits at voltages below a specified value, and prevents degradation of the logic transistors if the circuit is operated above its specified voltage. Such excessive voltage may be present in the testing of an integrated circuit. Other voltage limiting means can be envisioned; for example, a zener or avalanche diode can replace the series string of diodes 52-54. Also, more elaborate voltage control means are possible (e.g., a band-gap reference) which can provide, if desired, compensation for temperature or processing variations.

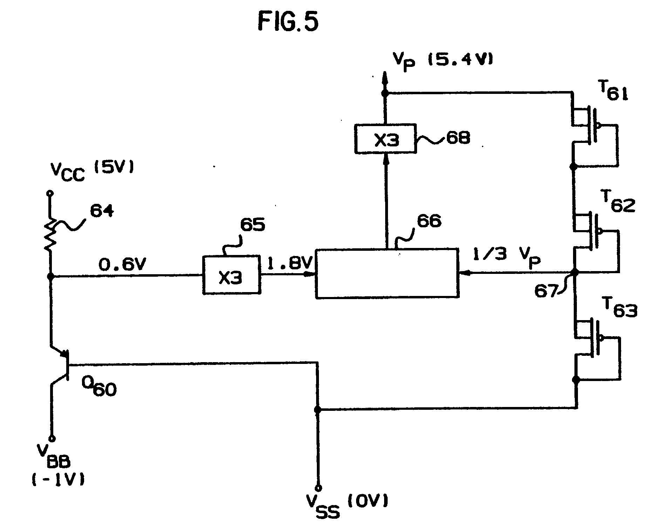

A presently preferred means for supplyig the protective voltage keeps $V_p$ at a substantially fixed level, regardless of power supply variations. Referring to FIG. 5, the protective voltage is derived from bipolar transistor $Q_{60}$, wherein a base-emitter voltage drop ($V_{BE}$) of about 0.6 volts is obtained. This voltage is multiplied 3 times in a voltage tripler 65, which may be of a conventional type. The 1.8 volts output is supplied to a comparator 66, which in turn supplies approximately 1.8 volts to a second voltage tripler 68 to produce a protective voltage $V_p$ of about 5.4 volts. This voltage is also supplied to a series string of p-channel transistors $T_{61}$-$T_{63}$. Each of these transistor has its source connected to its substrate, which is possible when each transistor is formed in a separate n-tub, according to principles known in the art. The three transistors $T_{61}$-$T_{63}$ serve as a voltage divider, with each one dropping an equal voltage thereacross, between $V_p$ and $V_{SS}$ (0 volts). Hence, a voltage of 1/3 $V_p$ appears at node 67, and is supplied to comparator 66. The comparator compares the 1/3 $V_p$ voltage to the 1.8 volts derived from $Q_{60}$, and adjusts the voltage supplied to tripler 68 to maintain them equal. The resulting $V_p$ (5.4 volts) is substantially independent of power supply voltage changes over the expected operating range, including excursions to high voltage levels for testing purposes (e.g., +V = 7 volts). Note that this circuit also maintains $V_p$ at a constant value when +V drops to values below 5 volts, so that performance of the logic circuits is not degraded by $V_p$ being too low.

While the foregoing description has illustrated the protection of n-channel devices, the protection of p-channel devices can be similarly provided for by the present technique. Future reliability concerns may make that desirable in lieu of, or in addition to, the n-channel protection. For this purpose, a p-channel protective transistor can be provided, serially connected with one or more p-channel logic transistors and having a gate voltage at a desired protective value. This value is typically less than one threshold voltage drop more negative than the negative power supply voltage applied to the logic circuit. The output is then taken from the node common to the p-channel protective transistor and one or more n-channel logic transistors, in analogy to the foregoing. Note also that the protective transistor typically limits the voltage across the protected transistor to less than the nominal power supply voltage (e.g., less than 5 volts). However, it is possible to set the limit at a higher value, in order to protect only against aging effects during high-voltage burn-in testing, or during high-voltage transients that might be encountered in operation.

The present technique thus provides for protection for devices in integrated circuits by limiting the operating voltage on desired logic devices to less than the voltage across the power terminals. This is accomplished while still providing the output voltage swing defined by the power supply voltage, and also retaining the full power supply voltage for use in other portions of the circuit, as desired.

## Claims

1. An integrated circuit including a logic circuit having first and second terminals for connection to a power supply voltage (V +, ground), a first field effect transistor of a first conductivity type (T21,T31), a second field effect transistor of a second conductivity type opposite to said first conductivity type (T23,T34), the gates of said transistors being coupled to a common input node (24,37), the source of said first transistor being coupled to the first terminal and its drain being coupled to an output node, and the source of said second transistor being coupled to the second terminal, and an additional transistor of said second conductivity type (T22,T33) having its drain coupled to the output node of said logic circuit (25,35) and its source connected in the drain current path of said second transistor (T23,T34), CHARACTERIZED IN THAT said additional transistor is a voltage protective transistor for limiting the voltage across said second transistor, the gate of said protective transistor being coupled to means for supplying a regulated DC protective voltage ($V_p$) which remains relatively constant as compared to changes in said power supply voltage (V+) over at least a portion of an expected operating range.

2. An integrated circuit as claimed in claim 1 wherein said expected operating range includes test voltage levels that are higher than the nominal power supply voltage.

3. An integrated circuit as claimed in claim 1 or claim 2 wherein the nominal power supply voltage is in the range of from 4.5 to 5.5 volts.

4. An integrated circuit as claimed in claim 1, 2 or 3 wherein said transistors are silicon insulated gate field effect transistors.

5. An integrated circuit as claimed in any preceding claim wherein said second transistor and said protective transistor are n-channel transistors.

6. An integrated circuit as claimed in any preceding claim wherein said protective voltage is substantially constant over a nominal operating range of 4.5 to 5.5 volts.

7. An integrated circuit as claimed in any preceding claim wherein said protective voltage is derived from a voltage clamping circuit that includes a resistive element (R) coupled to voltage clamping means (52-54).

8. An integrated circuit as claimed in claim 7 wherein said voltage clamping means includes a string of forward biased diodes (52-54).

9. An integrated circuit as claimed in claim 7 wherein said voltage clamping means includes a zener or avalanche diode.

10. An integrated circuit as claimed in any one of claims 1 to 6 wherein said protective voltage is derived from a band-gap reference circuit.

11. An integrated circuit as claimed in any one of claims 1 to 6 wherein said protective voltage is produced by a circuit (FIG.5) that compares the voltage derived from a p-n junction (Q60) with a voltage derived by dividing said protective voltage to a lower value ($V_p$/3).

**Revendications**

1. Un circuit intégré comprenant un circuit logique ayant des première et seconde bornes prévues pour être connectées à une tension d'alimentation (V+, masse), un premier transistor à effet de champ d'un premier type de conductivité (T21, T31), un second transistor à effet de champ d'un second type de conductivité, opposé au premier type de conductivité (T23, T34), les grilles de ces transistors étant connectées à un noeud d'entrée commun (24, 37), la source du premier transistor étant connectée à la première borne et son drain étant connecté à un noeud de sortie, et la source du second transistor étant connectée à la seconde borne, et un transistor supplémentaire du second type de conductivité (T22, T33) dont le drain est connecté au noeud de sortie du circuit logique (25, 35) et dont la source est connectée dans le chemin de courant de drain du second transistor (T23, T34), CARACTERISE EN CE QUE le transistor supplémentaire est un transistor de protection de tension qui est destiné à limiter la tension aux bornes du second transistor, la grille de ce transistor de protection étant connectée à des moyens qui sont destinés à fournir une tension de protection continue régulée ($V_p$) qui reste relativement constante, en comparaison avec des variations de la tension d'alimentation (V+), sur au moins une partie de la plage de fonctionnement prévue.

2. Un circuit intégré selon la revendication 1, dans lequel la plage de fonctionnement prévue comprend des niveaux de tension de test qui sont supérieurs à la tension d'alimentation nominale.

3. Un circuit intégré selon la revendication 1 ou la revendication 2, dans lequel la tension d'alimentation nominale est dans la plage de 4,5 à 5,5 volts.

4. Un circuit intégré selon la revendication 1, 2 ou 3, dans lequel les transistors sont des transistors à effet de champ à grille isolée au silicium.

5. Un circuit intégré selon l'une quelconque des revendications précédentes, dans lequel le second transistor et le transistor de protection sont des transistors à canal n.

6. Un circuit intégré selon l'une quelconque des revendications précédentes, dans lequel la tension de protection est pratiquement constante sur une plage de fonctionnement nominale de 4, 5 à 5,5 volts.

7. Un circuit intégré selon l'une quelconque des revendications précédentes, dans lequel la tension de protection est obtenue à partir d'un circuit de limitation de tension qui comprend un élément résistif (R) connecté à des moyens de limitation de tension (52-54).

8. Un circuit intégré selon la revendication 7, dans lequel les moyens de limitation de tension comprennent une chaîne de diodes polarisées en direct (52-54).

9. Un circuit intégré selon la revendication 7, dans lequel les moyens de limitation de tension comprennent une diode zener ou une diode à avalanche.

10. Un circuit intégré selon l'une quelconque des revendications 1 à 6, dans lequel la tension de protection est obtenue à partir d'un circuit de référence à bande interdite.

11. Un circuit intégré selon l'une quelconque des revendications 1 à 6, dans lequel la tension de protection est produite par un circuit (figure 5) qui compare la tension obtenue à partir d'une jonction p-n (Q60) avec une tension qui est obtenue par division de la tension de protection pour donner une valeur inférieure ($V_p/3$).

**Ansprüche**

1. Integrierte Schaltung mit einer Logikschaltung, die einen ersten und einen zweiten Anschluß zur Anschaltung an eine versorgungsspannung (V +, Erde) besitzt, einem ersten Feldeffekttransistor (T21, T31) eines ersten Leitfähigkeitstyps, einem zweiten Feldeffekttransistor (T23, T34) eines zweiten, zum ersten entgegengesetzten Leitfähigkeitstyps, wobei die Gate-Elektrode der Transistoren mit einem gemeinsamen Eingangsknoten (24, 37), die Source-Elektrode des ersten Transistors mit dem ersten Anschluß und seine Drain-Elektrode mit einem Ausgangsknoten sowie die Source-Elektrode des zweiten Transistors mit dem zweiten Anschluß verbunden sind, und einem zusätzlichen Transistor (T22, T33) des zweiten Leitfähigkeitstyps, dessen Drain-Elektrode mit dem Ausgangsknoten der Logikschaltung (25, 35) verbunden ist und dessen Source-Elektrode in den Drain-Stromkreis des zweiten Transistors (T23, T34) geschaltet ist, dadurch gekennzeichnet, daß der zusätzliche Transistor ein Spannungsschutztransistor zur Begrenzung der Spannung über dem zweiten Transistor ist und daß die Gate-Elektrode des Schutztransistors mit einer Einrichtung zur Lieferung einer geregelten Schutzgleichspannung ($V_t$) verbunden ist, die im Vergleich zu Änderungen der Versorgungsspannung (V +) verhältnismäßig konstant über wenigstens einen Teil eines erwarteten Betriebsbereiches bleibt.

2. Integrierte Schaltung nach Anspruch 1, bei der erwartete Betriebsbereich Prüfspannungspegel enthält, die höher als die nominelle versorgungsspannung sind.

3. Integrierte Schaltung nach Anspruch 1 oder 2, bei der die nominelle Versorgungsspannung im Bereich von 4,5 bis 5,5 V liegt.

4. Integrierte Schaltung nach Anspruch 1, 2 oder 3, bei der die Transistoren Silicium-Feldeffekttransistoren mit isoliertem Gate sind.

5. Integrierte Schaltung nach einem der vorhergehenden Ansprüche, bei der der zweite Transistor und der Schutztransistor n-Kanal-Transistoren sind.

6. Integrierte Schaltung nach einem der vorhergehenden Ansprüche, bei der die Schutzspannung über den Nennbetriebsbereich von 4,5 bis 5,5 V im wesentlichen konstant ist.

7. Integrierte Schaltung nach einem der vorhergehenden Ansprüche, bei der die Schutzspannung aus einer Klemmspannungsschaltung abgeleitet ist, die ein mit einer Spannungsklemmeinrichtung (52-54) verbundenes Widerstandselement (R) enthält.

8. Integrierte Schaltung nach Anspruch 7, bei der die Spannungsklemmeinrichtung eine Kette von in Durchlaßrichtung vorgespannten Dioden (52-54) enthält.

9. Integrierte Schaltung nach Anspruch 7, bei der die Spannungsklemmeinrichtung eine Zener- oder Lawinendurchbruchsdiode enthält.

10. Integrierte Schaltung nach einem der Ansprüche 1 bis 6, bei der die Schutzspannung aus einer Bandlücken-Bezugsschaltung abgeleitet ist.

11. Integrierte Schaltung nach einem der Ansprüche 1 bis 6, bei der die Schutzspannung durch eine Schaltung (Fig. 5) erzeugt wird, die die von einem pn-Übergang (60) abgeleitete Spannung mit einer Spannung vergleicht, die durch Teilen der Schutzspannung auf einen kleineren Wert ($V_p/3$) abgeleitet ist.

# FIG. I

# FIG.2

# FIG.3

# FIG.4

# FIG.5

EP 0 204 762 B1